# EUROPEAN PATENT APPLICATION

(11) **EP 4 748 571 A1**
(43) Date of publication of application: **27.05.2026**
(21) Application number: 24905644.1
(22) Date of filing: 02.09.2024
(51) Int. Cl.: B32B 27/36, G09F 9/30

(54) **STACK STRUCTURE, DISPLAY MODULE, ELECTRONIC DEVICE, IMPACT-RESISTANT LAYER AND PREPARATION METHOD THEREFOR**

(30) Priority: 22.12.2023 CN 202311792584
(71) Applicant: Huawei Technologies Co., Ltd., Shenzhen, Guangdong 518129 (CN)
(72) Inventor: LONG, Haohui, Shenzhen, Guangdong 518129 (CN); WANG, Jie, Shenzhen, Guangdong 518129 (CN); LV, Chengling, Shenzhen, Guangdong 518129 (CN); SU, Gang, Shenzhen, Guangdong 518129 (CN); XIAO, Tian, Shenzhen, Guangdong 518129 (CN)
(74) Representative: Körber, Martin Hans
(86) International application number: PCT/CN2024/116410
(87) International publication number: WO 2025/130152

(57) **Abstract**

A laminated structure (90), a display module (2), an electronic device (1), an impact-resistant layer, and a preparation method are disclosed, and relate to the field of display technologies. The laminated structure (90) includes a protective layer (91) and the impact-resistant layer. An elastic modulus of the impact-resistant layer is less than an elastic modulus of the protective layer (91), hardness of the impact-resistant layer is greater than hardness of the protective layer (91), and/or stiffness of the impact-resistant layer is greater than stiffness of the protective layer (91). The protective layer (91) is connected to the impact-resistant layer through bonding or in another manner. In this case, an extrusion resistance property of a material with high hardness and/or high stiffness and an impact resistance property of a material with a high elastic modulus are combined, to improve reliability of the laminated structure (90). The laminated structure (90) is directly connected to a display (20) through an adhesive layer, and a structure of a display surface layer plus a cover is no longer required, so that an architecture of the electronic device (1) can be simplified.

## Description

This application claims priority to Chinese Patent Application No. 202311792584.6, filed with the China National Intellectual Property Administration on December 22, 2023 and entitled "LAMINATED STRUCTURE, DISPLAY MODULE, ELECTRONIC DEVICE, IMPACT-RESISTANT LAYER, AND PREPARATION METHOD THEREFOR", which is incorporated herein by reference in its entirety.

### TECHNICAL FIELD

This application relates to the field of display technologies, and in particular, to a laminated structure, a display module, an electronic device, an impact-resistant layer, and a preparation method therefor.

### BACKGROUND

With continuous development of display technologies, foldable electronic devices gradually become a development trend of future mobile electronic products. The foldable electronic device in an unfolded state can have a large display area, thereby improving a viewing effect. The foldable electronic device in a folded state can have a small size, and therefore is convenient for a user to carry.

A flexible display is an important component of the foldable electronic device. Due to special properties of a material of the flexible display, the display is prone to damage under an external force. In view of this, a screen protective layer is usually disposed on a light-emitting side of the display. The entire electronic device needs to be bendable. Therefore, the screen protective layer also needs to be bendable. In this case, cover glass in a bar-type electronic device is no longer applicable to the foldable electronic device, and a polymer material is selected to protect the display.

To ensure reliability of the display, a plurality of polymer film layers usually need to be disposed on the light-emitting side and a backlight side of the display. Consequently, a formed display film layer has a series of problems such as a complex structure, a large quantity of process steps, a large thickness, and low reliability.

### SUMMARY

Embodiments of this application provide a laminated structure, a display module, an electronic device, an impact-resistant layer, and a preparation method therefor, to simplify an architecture of the electronic device while improving reliability.

To achieve the foregoing objective, the following technical solutions are used in this application.

According to a first aspect of embodiments of this application, a laminated structure is provided. The laminated structure is disposed on a display and is located on a light-emitting side of the display. The laminated structure includes a protective layer and a first impact-resistant layer. The first impact-resistant layer is located on a side of the protective layer, and the first impact-resistant layer is connected to the protective layer. An elastic modulus of the first impact-resistant layer is less than an elastic modulus of the protective layer, hardness of the first impact-resistant layer is greater than hardness of the protective layer, and/or stiffness of the first impact-resistant layer is greater than stiffness of the protective layer.

In the laminated structure provided in embodiments of this application, the first impact-resistant layer with high hardness and/or high stiffness is stacked with the protective layer with a high elastic modulus, so that an extrusion resistance property of a material with high hardness and/or high stiffness and an impact resistance property of a material with a high elastic modulus are combined, and the laminated structure includes a plurality of impact-resistant layers. In this way, impact resistance performance, scratch resistance performance, extrusion resistance performance, and bending resistance performance of the laminated structure can be improved, and fineness of a crease and a large-area light shadow can be improved, thereby improving reliability and fineness of the laminated structure. In addition, the first impact-resistant layer is connected to the protective layer. This helps implement a thinning design of the laminated structure, reduce opening and closing resistance during bending, and further improve reliability and fineness of the laminated structure. Moreover, the laminated structure may be directly and independently disposed on the light-emitting side of the display, and a display surface layer and a cover layer are integrated, to simplify an architecture of an electronic device.

In a possible implementation, the protective layer is bonded to the first impact-resistant layer. The first impact-resistant layer and the protective layer are bonded to form a composite laminated structure, and no connection layer needs to be added between the first impact-resistant layer and the protective layer. This helps implement the thinning design of the laminated structure, reduce the opening and closing resistance during bending, and further improve reliability and fineness of the laminated structure.

In a possible implementation, the laminated structure further includes a first connection layer, and the first connection layer is bonded between the protective layer and the first impact-resistant layer. The protective layer is connected to the first impact-resistant layer through the connection layer, and the laminated structure may include at least three film layer structures. This helps implement the thinning design of the laminated structure.

In a possible implementation, the laminated structure further includes a second impact-resistant layer, and the second impact-resistant layer is located on a side that is of the first impact-resistant layer and that is away from the protective layer. The first connection layer wraps a surface that is of the first impact-resistant layer and that is away from the protective layer, and the second impact-resistant layer is bonded to the first connection layer. The laminated structure may include the plurality of impact-resistant layers. The plurality of impact-resistant layers are disposed by reducing a thickness of each impact-resistant layer, so that overall stiffness and hardness of the plurality of impact-resistant layers remain unchanged, but an elastic modulus of the plurality of impact-resistant layers can be increased, to further improve the impact resistance performance, the scratch resistance performance, the extrusion resistance performance, and the bending resistance performance of the laminated structure. In addition, the plurality of impact-resistant layers may be directly bonded through the first connection layer, to simplify the laminated structure.

In a possible implementation, the laminated structure further includes a second impact-resistant layer and a second connection layer, the second impact-resistant layer is located on a side that is of the first impact-resistant layer and that is away from the protective layer, and the second connection layer is connected between the first impact-resistant layer and the second impact-resistant layer. The plurality of impact-resistant layers may also be connected in a plurality of manners such as chemical bonding and adhering through a connection layer, and has a wide application scope.

In a possible implementation, a material of the first impact-resistant layer includes ultra-thin glass or high-entropy glass. The ultra-thin glass and the high-entropy glass have good elasticity and recoverability. In a simplified architecture with multiple ultra-thin glass or high-entropy glass, recoverability of the crease is greatly improved.

In a possible implementation, a material of the protective layer includes polyethylene terephthalate, colorless polyimide, or glass fiber. This is a polymer material with a high elastic modulus and mature technology.

In a possible implementation, a material of the first connection layer includes an energy-absorbing and impact-resistant material. The first impact-resistant layer and the protective layer are chemically bonded through the energy-absorbing and impact-resistant material, so that a connection effect is good, and a thickness of the first connection layer may be thin.

In a possible implementation, a material of the second connection layer includes a polymer material or an energy-absorbing and impact-resistant material, and the second connection layer is bonded to the first impact-resistant layer and the second impact-resistant layer. The first impact-resistant layer and the second impact-resistant layer are chemically bonded through the polymer material or the energy-absorbing and impact-resistant material, so that a connection effect is good, and a thickness of the second connection layer may be thin.

In a possible implementation, the material of the second connection layer includes an adhesive material, and the second connection layer is separately adhered to the first impact-resistant layer and the second impact-resistant layer. The first impact-resistant layer and the second impact-resistant layer are connected through the adhesive material. A technology is mature and easy to implement.

In a possible implementation, a groove is provided on a surface that is of the first impact-resistant layer and that faces the protective layer and/or the surface that is of the first impact-resistant layer and that is away from the protective layer. The groove is provided on the first impact-resistant layer, to reduce a thickness of a middle region of the first impact-resistant layer, so that the first impact-resistant layer has bending performance while ensuring reliability, and a risk of breaking the first impact-resistant layer is reduced.

In a possible implementation, a size of the first impact-resistant layer at a thinnest position is less than or equal to 50 µm. In this way, both reliability and a rebound force of the first impact-resistant layer can be ensured, to optimize performance of the first impact-resistant layer.

In a possible implementation, a thickness of the laminated structure is less than or equal to 600 µm. The laminated structure provided in embodiments of this application can be thin while ensuing reliability, to satisfy a requirement of lightening and thinning the electronic device.

In a possible implementation, a side surface of the laminated structure is perpendicular to the protective layer. In this way, protection strength of the laminated structure at each position of the display is almost the same, and a problem of a poor protection effect at an edge of the display is alleviated.

In a possible implementation, the laminated structure further includes a third connection layer and a third impact-resistant layer that are sequentially disposed on a side that is of the second impact-resistant layer and that is away from the second connection layer. The plurality of impact-resistant layers are disposed by reducing the thickness of each impact-resistant layer, so that the overall stiffness and hardness of the plurality of impact-resistant layers remain unchanged, but the elastic modulus of the plurality of impact-resistant layers can be increased, to further improve the impact resistance performance, the scratch resistance performance, the extrusion resistance performance, and the bending resistance performance of the laminated structure.

According to a second aspect of embodiments of this application, a laminated structure is provided. The laminated structure includes: a protective layer; a first connection layer, adhered between the protective layer and a first impact-resistant layer; the first impact-resistant layer, located on a side of the protective layer; a second impact-resistant layer, located on a side that is of the first impact-resistant layer and that is away from the protective layer; and a second connection layer, bonded between the first impact-resistant layer and the second impact-resistant layer. An elastic modulus of the first impact-resistant layer is less than an elastic modulus of the protective layer, hardness of the first impact-resistant layer is greater than hardness of the protective layer, and/or stiffness of the first impact-resistant layer is greater than stiffness of the protective layer. The laminated structure provided in embodiments of this application includes a plurality of impact-resistant layers. The plurality of impact-resistant layers are disposed by reducing a thickness of each impact-resistant layer, so that overall stiffness and hardness of the plurality of impact-resistant layers remain unchanged, but an elastic modulus of the plurality of impact-resistant layers can be increased, to further improve impact resistance performance, scratch resistance performance, extrusion resistance performance, and bending resistance performance of the laminated structure. In addition, the plurality of impact-resistant layers may be directly bonded through the first connection layer, to simplify the laminated structure.

According to a third aspect of embodiments of this application, a display module is provided. The display module includes a display and a laminated structure, the laminated structure includes the laminated structure according to any one of the first aspect and the second aspect, and a light-emitting surface of the display faces a second impact-resistant layer.

In a possible implementation, the display module further includes a first adhesive layer, a buffer layer, a second adhesive layer, and a bracket that are sequentially disposed on a backlight surface of the display, the buffer layer is connected to the display through the first adhesive layer, and the bracket is connected to the buffer layer through the second adhesive layer. A support layer is no longer disposed on the backlight surface of the display, so that an architecture of the display module can be further simplified, a thickness of the display module can be reduced, and the display module can be simplified, light, and thin.

In a possible implementation, an elastic modulus of the bracket is greater than or equal to 10 GPa. A material with a high elastic modulus is selected as a material of the bracket, so that impact resistance performance of the bracket can be improved, and fineness of a crease and a large-area light shadow can be improved, thereby improving reliability and fineness of the display module while simplifying the architecture of the display module.

In a possible implementation, the bracket includes a first part and a second part, the second part is separately disposed on two opposite sides of the first part, and an elastic modulus of the first part is less than an elastic modulus of the second part. An elastic modulus in a middle region of the bracket is reduced, so that bendability of a middle bending region can be ensured, and performance of the display module can be further improved.

In a possible implementation, a material of the bracket includes carbon fiber, graphite fiber, asphalt base, a high-entropy alloy, stainless steel, a titanium alloy, a composite material of asphalt base and metal, or a composite material of carbon fiber and metal. The bracket may be made of a plurality of existing materials, and no new material needs to be developed. This is easy to implement.

In a possible implementation, a projection of the laminated structure on the buffer layer covers a projection of the display on the buffer layer. The laminated structure can protect the display, to alleviate a problem that a weak edge extrusion region is prone to damage, and further improve reliability of the display module.

In a possible implementation, the display module further includes a third adhesive layer, and two sides of the third adhesive layer are respectively connected to the laminated structure and the display. The laminated structure and the display are directly adhered through the third adhesive layer, and no other film layer needs to be disposed between the laminated structure and the display. This can simplify a structure of the display module, and reduce a gap between the display and the laminated structure, thereby reducing an overall size of the display module.

In a possible implementation, the display includes a first plane portion, a bending portion, and a second plane portion, the bending portion is connected between the first plane portion and the second plane portion, the first plane portion is connected to the laminated structure, and the second plane portion is located on a backlight side of the first plane portion. The display module further includes a module coating layer, the module coating layer covers the bending portion, and a thickness of the module coating layer ranges from 50 µm to 90 µm. Only the third adhesive layer may be disposed between the display and the laminated structure. Therefore, a gap between the first plane portion and the laminated structure may be small, so that the thickness of the display module can be reduced. Moreover, no support layer needs to be disposed between the first plane portion and the second plane portion, so that the thickness of the module coating layer can be reduced.

According to a fourth aspect of embodiments of this application, an electronic device is provided. The electronic device includes a display module and a middle frame, the display module is disposed on the middle frame, and the display module includes the display module according to any one of the third aspect.

In a possible implementation, the electronic device further includes a side frame, and the side frame is located on a periphery of the display module and extends above a laminated structure to lap over the laminated structure. In this case, there is no gap between the side frame and the laminated structure, to improve an aesthetic effect and alleviate a dust absorption problem. In addition, the laminated structure protects an edge of the electronic device against pressing, so that a requirement of protecting the side frame can be reduced, to reduce a width of the side frame, and implement a "narrow side frame" effect.

In a possible implementation, a width of a projection of the side frame on a plane on which the display module is located is less than or equal to 0.5 mm. Because the laminated structure protects the edge of the electronic device against pressing, the side frame may not need to play a protective role, and the side frame only needs to fill a gap between the display module and the middle frame. Therefore, the width of the side frame can be reduced.

In a possible implementation, a side surface of the display module is disposed adjacent to the middle frame. Because the laminated structure protects the edge of the electronic device against pressing, the side frame may not need to play a protective role, and no side frame may need to be disposed between the display module and the middle frame, to further implement the "narrow side frame" effect.

In a possible implementation, the electronic device further includes a rear cover, the rear cover includes a first housing, a second housing, and a hinge mechanism, and the first housing and the second housing are disposed on two sides of the hinge mechanism. The first housing and the second housing move towards or away from each other through the hinge mechanism, so that the display module is switched between an unfolded state and a folded state. The electronic device in this application is applicable to a foldable electronic device.

According to a fifth aspect of embodiments of this application, a method for preparing an impact-resistant layer is provided, including: providing a raw material of glass; placing the raw material of glass in a thermal casting fixture with a protrusion on an inner surface to perform thermal casting, to form a glass plate with a groove on a surface; and trimming the glass plate to a target size to form the impact-resistant layer, where there is a groove on an upper surface and/or a lower surface of the impact-resistant layer.

In embodiments of this application, the impact-resistant layer may be formed by using a thermal casting process, so that processing efficiency and processability of the impact-resistant layer with unequal thicknesses can be improved, and mass production can be implemented.

In a possible implementation, before or after trimming the glass plate to the target size, the preparation method further includes: polishing the glass plate. In this way, optical performance of the impact-resistant layer can be improved.

In a possible implementation, trimming the glass plate to the target size includes: trimming a length and a width of the glass plate through laser or computer numerical control machining. In this way, a processing technology is simple, and a yield rate is high.

In a possible implementation, a thickness of the glass plate is trimmed by using an etching process. In this way, a processing technology is simple, and a yield rate is high.

In a possible implementation, a temperature of the thermal casting ranges from 600°C to 1000°C. In this way, a processing technology is simple, and a yield rate is high.

According to a sixth aspect of embodiments of this application, an impact-resistant layer is provided. The impact-resistant layer is used in an electronic device including a display, the impact-resistant layer has a first surface and a second surface that are opposite to each other, and there is a groove on the first surface and/or the second surface.

The groove is provided on the impact-resistant layer, to reduce a thickness of a middle region of the impact-resistant layer, so that the impact-resistant layer has bending performance while ensuring reliability, and a risk of breaking the impact-resistant layer is reduced.

In a possible implementation, a material of the impact-resistant layer includes ultra-thin glass or high-entropy glass. The ultra-thin glass and the high-entropy glass have good elasticity and recoverability, so that recoverability of a crease of the impact-resistant layer is greatly improved.

In a possible implementation, a size of the impact-resistant layer at a thinnest position is less than or equal to 50 µm. In this way, both reliability and a rebound force of the impact-resistant layer can be ensured, to optimize performance of the impact-resistant layer.

According to a seventh aspect of embodiments of this application, a thermal casting fixture is provided, including a first component and a second component. There is a protrusion on a surface that is of the first component and that faces the second component, and/or there is a protrusion on a surface that is of the second component and that faces the first component.

### BRIEF DESCRIPTION OF DRAWINGS

FIG. 1A is a diagram of a structure of an electronic device according to an embodiment of this application;
FIG. 1B is a diagram of an electronic device in a folded state according to an embodiment of this application;
FIG. 1C is a cross-sectional view of a bar-type electronic device according to an embodiment of this application;
FIG. 1D is a simplified diagram of a display module according to an embodiment of this application;
FIG. 1E is a sectional view in a direction A1-A2 in FIG. 1A according to an embodiment of this application;
FIG. 1F is a cross-sectional view of a display according to an embodiment of this application;
FIG. 1G is an enlarged view of a position A in FIG. 1F;
FIG. 2 is a cross-sectional view of a laminated structure according to an embodiment of this application;
FIG. 3A to FIG. 3C are cross-sectional views of a laminated structure according to an embodiment of this application;
FIG. 4A to FIG. 4C are cross-sectional views of a laminated structure according to an embodiment of this application;
FIG. 5 is a cross-sectional view of a laminated structure according to an embodiment of this application;
FIG. 6A is a cross-sectional view of a display module according to an embodiment of this application;
FIG. 6B is a simplified diagram of a display module according to an embodiment of this application;
FIG. 7A to FIG. 7C are assembly diagrams of an electronic device according to an embodiment of this application;
FIG. 8A and FIG. 8B are cross-sectional views of an electronic device according to an embodiment of this application; and
FIG. 9 is a diagram of a process of preparing an impact-resistant layer according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms "second", "first", and the like below are merely intended for ease of description, and shall not be understood as an indication or implication of relative importance or an implicit indication of a quantity of indicated technical features. Therefore, a feature limited by "second", "first", or the like may explicitly or implicitly include one or more features. In the descriptions of this application, unless otherwise stated, "a plurality of" means two or more than two.

In addition, in embodiments of this application, orientation terms such as "upper", "lower", "left", and "right" may include but are not limited to definitions based on illustrated orientations in which components in the accompanying drawings are placed. It should be understood that these directional terms may be relative concepts and are used for relative description and clarification, and may change accordingly based on changes in the placement orientations of the components in the accompanying drawings.

In embodiments of this application, unless otherwise clearly specified and limited, the term "connection" should be understood in a broad sense. For example, the "connection" may be a fixed connection, a detachable connection, or an integrated connection, or may be a direct connection or an indirect connection implemented through an intermediate medium. In addition, the term "coupling" may be a direct electrical connection, or may be an indirect electrical connection through an intermediate medium. The term "contact" may be direct contact or indirect contact through an intermediate medium.

In embodiments of this application, the term "and/or" describes an association relationship between associated objects and indicates that three relationships may exist. For example, A and/or B may indicate the following cases: Only A exists, both A and B exist, and only B exists, where A and B may be singular or plural. The character "/" generally indicates an "or" relationship between the associated objects.

Embodiments of this application provide an electronic device. The electronic device may be, for example, a foldable electronic device. Certainly, the electronic device may alternatively be a bar-type electronic device. In embodiments of this application, the electronic device may be a saleable electronic device. The electronic device is, for example, a consumer electronic product, a home electronic product, a vehicle-mounted electronic product, or a financial electronic product. The consumer electronic product is, for example, a mobile phone (mobile phone), a tablet computer (pad), a notebook computer, an e-reader, a personal computer (personal computer, PC), a personal digital assistant (personal digital assistant, PDA), a desktop display, an intelligent wearable product (for example, a smartwatch or a smart band), a virtual reality (virtual reality, VR) electronic device, an augmented reality (augmented reality, AR) electronic device, an uncrewed aerial vehicle, or a server. The home electronic product is, for example, a smart door lock, a television, a remote control, a refrigerator, a small household charging appliance (for example, a soy milk maker or a robot vacuum), or a switch. The vehicle-mounted electronic product is, for example, a vehicle-mounted navigator or a vehicle-mounted DVD. The financial electronic product is, for example, an ATM machine or an electronic device for self-service.

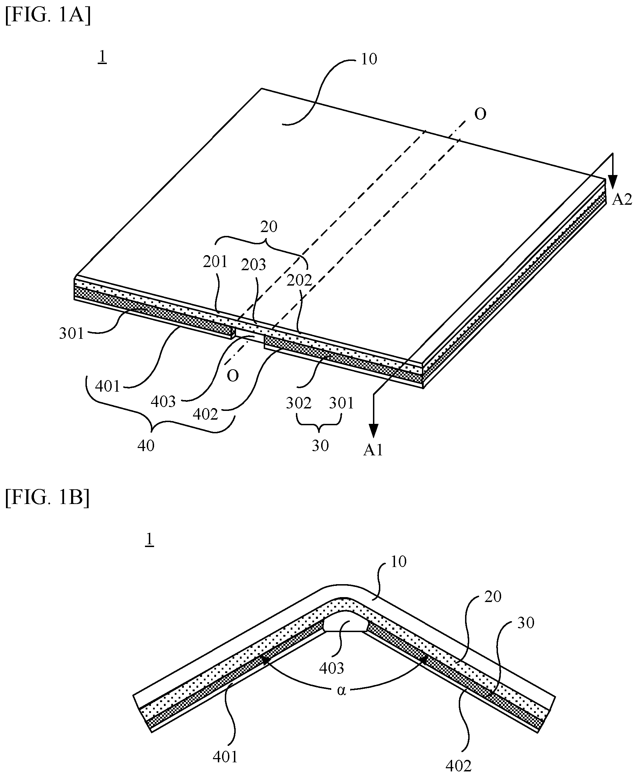

FIG. 1A is a diagram of a structure of an electronic device according to an embodiment of this application. FIG. 1B is a diagram of an electronic device in a folded state according to an embodiment of this application.

To facilitate understanding of the electronic device provided in embodiments of this application, the following describes an existing electronic device with reference to FIG. 1A.

As shown in FIG. 1A, an electronic device 1 includes a screen protective layer 10, a display 20, a middle frame 30, and a rear cover (or referred to as a rear housing, a battery cover, or the like) 40. The screen protective layer 10 is disposed on the display 20 and is located on a light-emitting side of the display 20. The display 20 is disposed on the middle frame 30, and the middle frame 30 is configured to bear the display 20. The rear cover 40 covers the middle frame 30, and forms accommodation space with a side that is of the middle frame 30 and that is away from the display 20.

For example, the electronic device 1 is a foldable electronic device, and the display 20 is a flexible display. The display 20 is a self-luminous display, and a backlight module (backlight module, BLM) does not need to be disposed. The display 20 is a self-luminous display like an organic light-emitting diode (organic light-emitting diode, OLED) display, an active-matrix organic light-emitting diode (active-matrix organic light-emitting diode, AMOLED) display, a mini organic light-emitting diode (mini organic light-emitting diode, Mini-OLED) display, a micro light-emitting diode (micro light-emitting diode, Micro-LED) display, a micro organic light-emitting diode (micro organic light-emitting diode, Micro-OLED) display, or a quantum dot light-emitting diode (quantum dot light-emitting diode, QLED) display.

The middle frame 30 includes a first frame body 301 and a second frame body 302. The first frame body 301 and the second frame body 302 may be configured to: bear the flexible display 20, so that the flexible display 20 keeps flat during use, and protect a non-display surface of the flexible display 20. For example, a part of the flexible display 20 is fastened to the first frame body 301 through an adhesive layer, and a part of the flexible display 20 is fastened to the second frame body 302 through an adhesive layer. The adhesive layer may be a thin film layer formed after an adhesive is applied. A specific form of the adhesive layer is not limited in embodiments of this application. In addition, another electronic component, for example, a printed circuit board (printed circuit board, PCB), a battery, a receiver, a speaker, or a camera (camera), may be further disposed on a side that is of the first frame body 301 and the second frame body 302 and that is away from the display 20. The PCB may integrate electronic components such as a main controller, a storage unit, an antenna module, and a power management module of the electronic device. The battery may supply power to the electronic components such as the display 20, the circuit board, the receiver, the speaker, and the camera. Certainly, electronic components disposed on the first frame body 301 and the second frame body 302 are not limited in embodiments of this application.

The rear cover 40 includes a first housing 401, a second housing 402, and a hinge mechanism 403. The first housing 401 and the second housing 402 are disposed on two sides of the hinge mechanism 403. In some embodiments, the display 20 may include a first display portion 201 corresponding to the first housing 401, a second display portion 202 corresponding to the second housing 402, and a foldable display portion 203 corresponding to the hinge mechanism 403. The foldable display portion 203 may be connected between the first display portion 201 and the second display portion 202. The first display portion 201 may be connected to the first frame body 301, and the second display portion 202 may be connected to the second frame body 302.

Under an action of the hinge mechanism 403, the first housing 401 and the second housing 402 may be close to or away from each other. Correspondingly, the first display portion 201 of the display 20 and the second display portion 202 of the display 20 may be close to or away from each other, so that the display 20 may be folded or unfolded.

As shown in FIG. 1B, in a folded state, an angle α between the first housing 401 and the second housing 402 may be rotated from 180° to an angle at which the first housing 401 and the second housing 402 are disposed in parallel and opposite to each other, and a spacing distance between the first housing 401 and the second housing 402 is the shortest. In this case, the first display portion 201 and the second display portion 202 may be considered as being disposed on different planes. FIG. 1B shows an example in which when the electronic device 1 is folded, the display 20 faces outwards, and the first housing 401 and the second housing 402 face each other (outward folding). Similarly, when the electronic device 1 is folded, the display 20 may alternatively face inwards, and the first display portion 201 and the second display portion 202 face each other (inward folding). In the folded state, the first display portion 201 and the second display portion 202 may be disposed in parallel and opposite to each other, and a spacing height between the first display portion 201 and the second display portion 202 is the smallest. Certainly, the electronic device 1 is not limited to be a two-fold electronic device 1, and the electronic device 1 may alternatively be a multi-fold electronic device 1. This is not limited in embodiments of this application.

As shown in FIG. 1A, in an unfolded state, the angle α between the first housing 401 and the second housing 402 may be about 180°, and the display 20 is in an unfolded state.

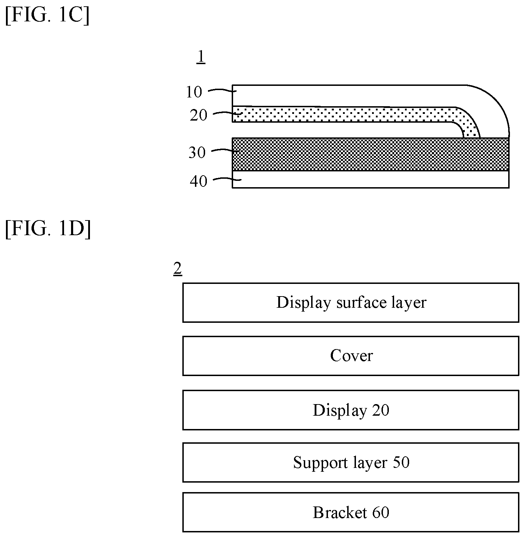

FIG. 1C is a cross-sectional view of a bar-type electronic device according to an embodiment of this application.

As shown in FIG. 1C, compared with a laminated electronic device, the bar-type electronic device has a simple structure, and may be simplified into a four-layer structure. First, a cover (cover) layer is used as a screen protective layer 10. A material of the cover layer is usually glass (glass), and a thickness of the cover layer is usually 500 µm or above. A display (or referred to as a display panel, panel) 20 is below the screen protective layer 10. The display 20 includes an OLED light-emitting layer, a thin film transistor (thin film transistor, TFT) circuit, and upper and lower packaging layers, and has a light-emitting function. A middle frame 30 is below the display 20. A support layer like copper foil may be disposed between the middle frame 30 and the display 20. The middle frame 30 and the rear cover 40 are assembled to form accommodation space.

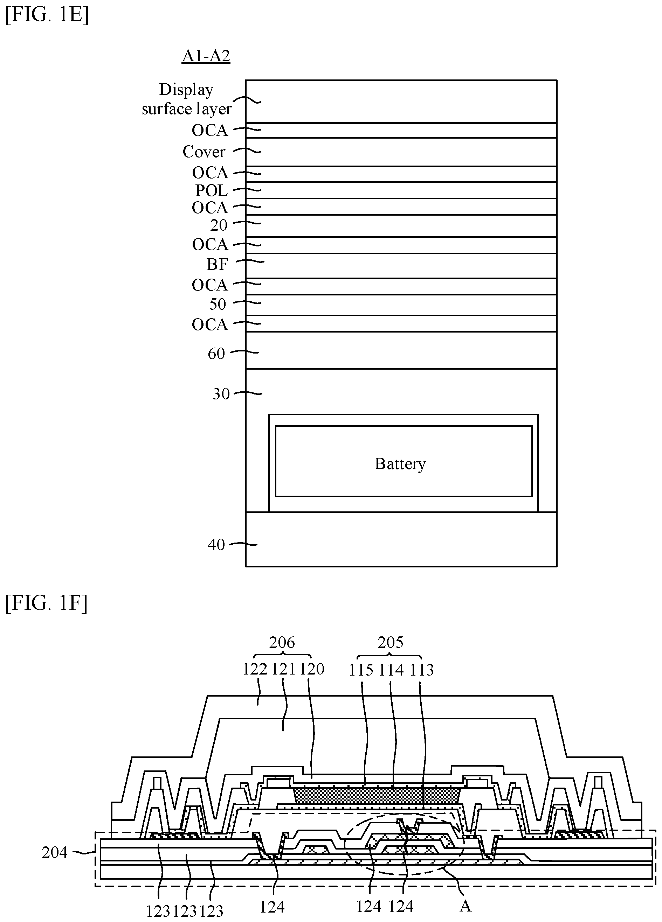

FIG. 1D is a simplified diagram of a display module according to an embodiment of this application. FIG. 1E is a sectional view in a direction A1-A2 in FIG. 1A according to an embodiment of this application.

A structure of the foldable electronic device is complex. A structure above the middle frame 30 may be understood as a display module provided in embodiments of this application. As shown in FIG. 1D, a display module 2 may be simplified to include a five-layer structure. The topmost layer is a display surface layer, located at the outermost of the display 20, and can protect reliability of the display. A cover layer is below the display surface layer, and plays a protective role. The screen protective layer 10 includes two layers: the display surface layer and the cover layer. The display 20 is below the cover layer. A support layer 50 and a bracket 60 are disposed on a backlight surface of the display 20. As shown in FIG. 1E, several main laminated layers are adhered through an optically clear adhesive (optically clear adhesive, OCA).

As shown in FIG. 1E, a polarizer (polarizer, POL) or polyethylene terephthalate (polyethylene terephthalate, PET) layer may be further disposed on the light-emitting side of the display 20. One or more buffer (buffer, BF) layers may be further disposed on a backlight side of the display 20, and a material of the support layer 50 may include, for example, polyimide (polyimide, PI).

The second frame body 302 in the middle frame 30 is disposed below the bracket 60. The bracket 60 and the middle frame 30 may be adhered through, for example, the OCA. The second housing 402 and the second frame body 302 are assembled to form accommodation space, and the battery is located in the accommodation space.

Because the foldable display 20 needs to be bendable, a material of a cover on the light-emitting side of the display 20 needs to be changed from glass to a foldable and flexible material. In existing electronic devices, reliability of the foldable display 20 is lower than that of a bar-type display. In a scenario in which the display 20 is subjected to a force like a drop impact or a bump of a boss, because a surface of the display is mostly of a polymer structure, the display 20 is prone to failures such as a black spot and a broken bright spot. Therefore, reliability of the display 20 in the foldable electronic device is lower than that of the display 20 in the bar-type electronic device. In addition, because the foldable display 20 needs to specifically have bendable performance, after a glass cover is changed to a cover made of a polymer material, a thickness of the entire display module 2 cannot be excessively thin. After the thickness of the display module 2 becomes thin, not only reliability (such as an impact risk, an extrusion risk, and a screen reverse arching risk due to falling) of the entire display module cannot be ensured, but also fineness (for example, a large-area light shadow and a crease) of the display module 2 is challenged. In addition, to implement reliability and bendability of the foldable display 20, a multi-layer design is usually used in the display surface layer and the cover layer, to implement multi-layer neutral bendability under small-angle bending.

However, the cover layer in the foldable electronic device 1 is different from the glass cover in the bar-type electronic device 1. The glass cover has high strength, and is harder and more wear-resistant. The cover layer in the foldable electronic device 1 mainly uses a PET film and a colorless polyimide (colorless polyimide, CPI) film for protection. After being impacted, the display 20 cannot absorb sufficient energy or dissipate energy by using cover glass like the bar-type electronic device 1, and protection performance is poor.

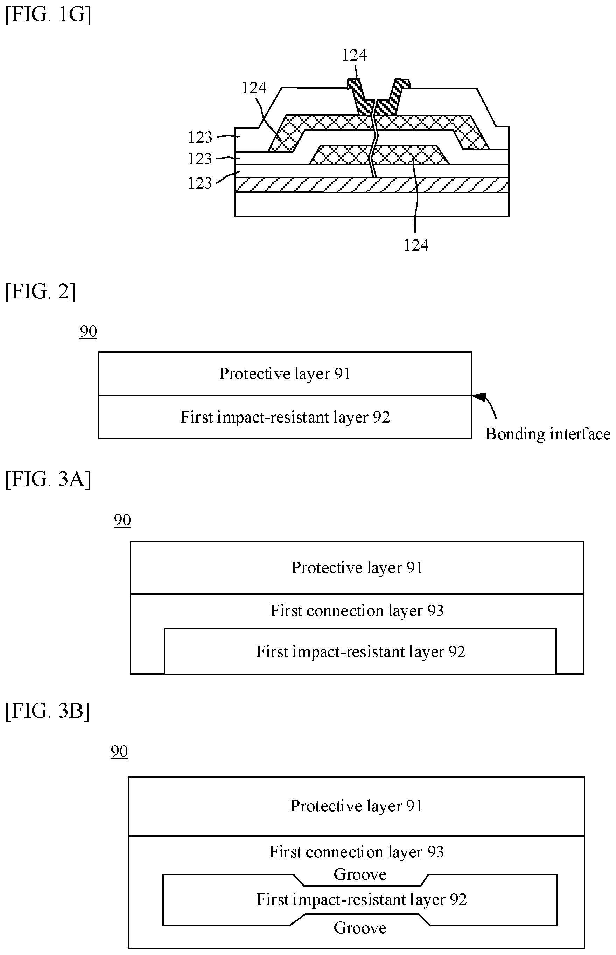

FIG. 1F is a cross-sectional view of a display according to an embodiment of this application. FIG. 1G is an enlarged view of a position A in FIG. 1F.

As shown in FIG. 1F, the display 20 usually includes an array substrate 204, a light-emitting device layer 205, and a packaging layer 206.

For example, the array substrate 204 may specifically include a substrate (or referred to as a backplane (backplane, BP)) 111 made of a PI material, and a plurality of inorganic insulation layers 123 and a plurality of metal layers 124 that are located on a side of the substrate 111. The plurality of inorganic insulation layers 123 and the plurality of metal layers 124 are configured to form electronic components such as a TFT and a capacitor.

The light-emitting device layer 205 may specifically include an anode 113, a light-emitting layer 114, and a cathode 115 that are stacked. When the electronic device is driven to emit light, an electronic component on an array layer 112 transmits a drive current to the anode 113, and an electron and a hole are separately injected into the light-emitting layer 114 for composite light emitting. Certainly, the light-emitting device layer 205 may further include a hole injection layer, a hole transport layer, an electron injection layer, an electron transport layer, or the like. FIG. 1F is merely an example.

The packaging layer 206 may specifically include a first inorganic packaging layer 120, an organic packaging layer 121, and a second inorganic packaging layer 122 that are stacked. The packaging layer 206 is configured to prevent external water and oxygen from penetrating, to protect a light-emitting device and an electronic component in the electronic device.

The array substrate 204 and the packaging layer 206 include a plurality of inorganic layers. Compared with an organic material, an inorganic material has a poorer bending resistance capability. Even if an organic packaging technology is subsequently used, the bending resistance capability is only improved to a specific extent, and there is still a specific gap with thick glass packaging.

When the electronic device 1 is bent or subjected to an external force, because the substrate 111 is thick and has no effective patterning, stress applied to the array substrate 204 cannot be released. When the stress accumulates and exceeds a cracking threshold of the substrate 111, the inorganic insulation layer 123, and the packaging layer 206, a film layer cracks, making it difficult to ensure impact resistance and bending reliability of the electronic device 1. In addition, as shown in FIG. 1G, cracking of the inorganic insulation layer 123 further causes a broken line of the metal layer 124 adjacent to the inorganic insulation layer 123, thereby causing an undesirable display phenomenon like a broken bright spot, a bright line, cracking, or peeling of the electronic device 1.

In conclusion, using such a multi-layer laminated design to protect the display 20 not only brings design complexity, but also brings challenges to process manufacturability and a supply chain. Therefore, problems related to structures, thicknesses, reliability, fineness, and the like of film layers on the two sides of the display 20 always need to be further resolved for the flexible electronic device 1.

In view of this, an embodiment of this application provides a laminated structure. The laminated structure is disposed on a light-emitting side of a display 20 as a screen protective layer 10, and is used in the electronic device 1. The laminated structure has specific improvements in reliability and thickness.

FIG. 2 is a cross-sectional view of the laminated structure according to this embodiment of this application.

As shown in FIG. 2, the laminated structure 90 includes a protective layer 91 and a first impact-resistant layer 92, and the protective layer 91 is connected to the first impact-resistant layer 92.

The protective layer 91 has a high elastic modulus, and serves as an explosion-proof protective layer. After the laminated structure 90 is used in the electronic device 1, the protective layer 91 is located on a surface layer on a display side of the electronic device 1, and can be directly touched.

A material of the protective layer 91 may include, for example, an explosion-proof material, an energy-absorbing and impact-resistant material, or a polymer material. For example, a modulus of the protective layer 91 ranges from 10 MPa to 20 GPa. For example, the material of the protective layer 91 includes PET, CPI, glass fiber, a CPI composite material, or the like.

The first impact-resistant layer 92 is located on a side of the protective layer 91. When the laminated structure 90 is used in the electronic device 1, the first impact-resistant layer 92 is located on a side that is of the protective layer 91 and that faces the display 20.

An elastic modulus of the first impact-resistant layer 92 is less than an elastic modulus of the protective layer 91, hardness of the first impact-resistant layer 92 is greater than hardness of the protective layer 91, and/or stiffness of the first impact-resistant layer 92 is greater than stiffness of the protective layer 91. The protective layer 91 is configured to provide an explosion-proof protection function, and the first impact-resistant layer 92 provides a function of improving reliability of the laminated structure 90.

For example, a material of the first impact-resistant layer 92 includes ultra-thin glass (ultra-thin glass, UTG) or high-entropy glass. The UTG and the high-entropy glass have good elasticity and recoverability. In a simplified architecture with multiple UTG or high-entropy glass, recoverability of a crease is greatly improved.

In the laminated structure 90 provided in this embodiment of this application, the first impact-resistant layer 92 with high hardness and/or high stiffness is stacked with the protective layer 91 with a high elastic modulus, so that an extrusion resistance property of a material with high hardness and/or high stiffness and an impact resistance property of a material with a high elastic modulus are combined. This can improve impact resistance performance, scratch resistance performance, extrusion resistance performance, and bending resistance performance of the laminated structure 90, and can improve fineness of a crease and a large-area light shadow, thereby improving reliability and fineness of the laminated structure 90. In addition, the first impact-resistant layer 92 is connected to the protective layer 91. This helps implement a thinning design of the laminated structure 90, reduce opening and closing resistance during bending, and further improve reliability and fineness of the laminated structure 90. Moreover, the laminated structure 90 may be directly and independently disposed on the light-emitting side of the display 20, and a display surface layer and a cover layer are integrated, to simplify an architecture of the electronic device 1.

In some embodiments, the protective layer 91 and the first impact-resistant layer 92 are bonded to implement a chemical connection.

For example, the material of the protective layer 91 includes CPI, the material of the first impact-resistant layer 92 includes UTG, and a crosslinking chemical reaction occurs between siloxane in the CPI and silicon hydroxyl in the UTG.

For example, a surface that is of the first impact-resistant layer 92 and that faces the protective layer 91 is a plane, and the first impact-resistant layer 92 is chemically bonded to the protective layer 91. Certainly, a surface that is of the first impact-resistant layer 92 and that is away from the protective layer 91 may be a plane, or may be a surface in another shape. This is not limited in embodiments of this application.

The first impact-resistant layer 92 and the protective layer 91 are designed as a composite laminated structure, and no connection layer needs to be added between the first impact-resistant layer 92 and the protective layer 91. This helps implement the thinning design of the laminated structure 90, reduce the opening and closing resistance during bending, and further improve reliability and fineness of the laminated structure 90.

FIG. 3A to FIG. 3C are cross-sectional views of a laminated structure according to an embodiment of this application.

In some embodiments, as shown in FIG. 3A, the laminated structure 90 further includes a first connection layer 93, and the first connection layer 93 is bonded between the protective layer 91 and the first impact-resistant layer 92.

For example, a material of the first connection layer 93 includes an energy-absorbing and impact-resistant material. For example, the material of the first connection layer 93 includes a non-Newtonian fluid material. The material of the protective layer 91 includes CPI, the material of the first impact-resistant layer 92 includes UTG, and the first connection layer 93 is chemically bonded to the protective layer 91 and the first impact-resistant layer 92.

For example, an empty orbital of a boron (B) atom in the non-Newtonian fluid material forms a coordination bond with a surplus electron pair on hydroxyl oxygen on a surface of a UTG layer, to implement chemical bonding between the first connection layer 93 and the first impact-resistant layer 92. An epoxy group or polyester in the non-Newtonian fluid material forms a coordination bond with an epoxy group on a CPI layer, to implement chemical bonding between the first connection layer 93 and the protective layer 91.

In an implementation, the first connection layer 93 may cover a top surface that is of the first impact-resistant layer 92 and that faces the protective layer 91, and is bonded to the top surface of the first impact-resistant layer 92.

In another implementation, as shown in FIG. 3A, the first connection layer 93 may cover a top surface and a side surface of the first impact-resistant layer 92, and is bonded to both the top surface and the side surface of the first impact-resistant layer 92.

In still another implementation, as shown in FIG. 3B, the first connection layer 93 may cover a top surface and a side surface of the first impact-resistant layer 92, and a bottom surface that is of the first impact-resistant layer 92 and that is away from the protective layer 91, and is bonded to all surfaces of the first impact-resistant layer 92.

For example, as shown in FIG. 3A, both a top surface that is of the first impact-resistant layer 92 and that faces the protective layer 91 and a bottom surface that is of the first impact-resistant layer 92 and that is away from the protective layer 91 are planes.

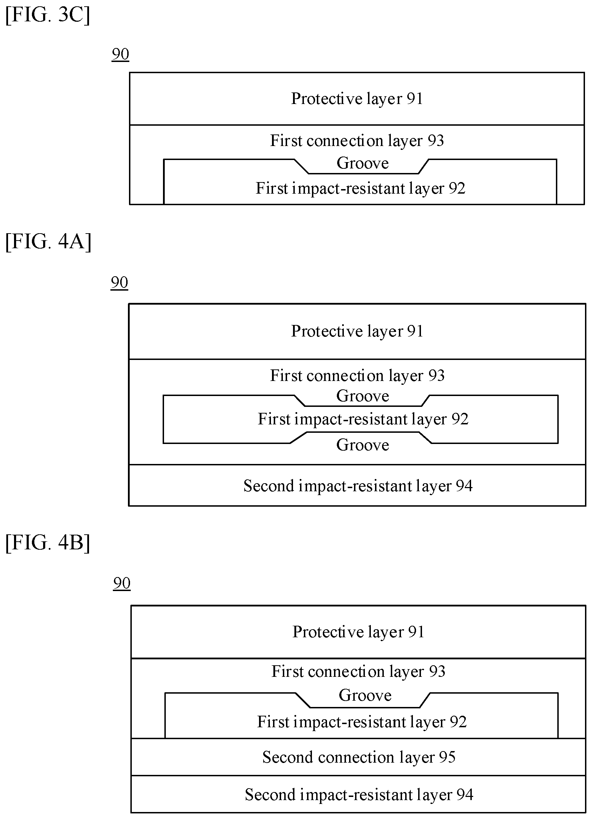

Alternatively, for example, as shown in FIG. 3C, there is a groove on a top surface that is of the first impact-resistant layer 92 and that faces the protective layer 91, and a bottom surface that is of the first impact-resistant layer 92 and that is away from the protective layer 91 is a plane.

Alternatively, for example, as shown in FIG. 3B, there is a groove on each of a top surface that is of the first impact-resistant layer 92 and that faces the protective layer 91 and a bottom surface that is of the first impact-resistant layer 92 and that is away from the protective layer 91.

For example, the groove on the first impact-resistant layer 92 is filled with a non-Newtonian fluid layer 92. Alternatively, for example, the groove on the first impact-resistant layer 92 is filled with a material like a separate filling adhesive. In this case, a film layer thickness of the first impact-resistant layer 92 at a groove position is less than a film layer thickness of the first impact-resistant layer 92 at another position. A shape of the groove is not limited in embodiments of this application. The groove may be a rectangular groove, an arc groove, a trapezoidal groove, or the like.

The groove is provided on the first impact-resistant layer 92, to reduce a thickness of a middle region of the first impact-resistant layer 92, so that the first impact-resistant layer 92 has bending performance while ensuring reliability, and a risk of breaking the first impact-resistant layer 92 is reduced.

In some embodiments, the first impact-resistant layer 92 has equal thicknesses at non-groove positions. For example, the first impact-resistant layer 92 is a film layer structure with equal thicknesses on two sides and a reduced thickness in the middle. Therefore, difficulty in preparing the first impact-resistant layer 92 can be reduced.

In some embodiments, a size of the first impact-resistant layer 92 at a thinnest position is less than or equal to 50 µm. Alternatively, it is understood as that a size of the first impact-resistant layer 92 at a position that is on a top surface and that is closest to a bottom surface is less than or equal to 50 µm.

A thickness of the first impact-resistant layer 92 may be selected based on reliability and a rebound force. For example, the size of the first impact-resistant layer 92 at the thinnest position may be 50 µm, 45 µm, 40 µm, 35 µm, 30 µm, 25 µm, 20 µm, 15 µm, 10 µm, 8 µm, 7 µm, 5 µm, 4 µm, 3 µm, or the like.

For example, the top surface and the bottom surface of the first impact-resistant layer 92 are both planes, the first impact-resistant layer 92 is a flat plate structure, and a thickness of the first impact-resistant layer 92 at each position is approximately less than or equal to 50 µm.

Alternatively, for example, there is a groove on each of the top surface and the bottom surface of the first impact-resistant layer 92. Thicknesses at groove positions may be equal or unequal based on different groove structures, but the thickness at the groove position is less than a thickness at a non-groove position. For example, a thinnest size at the groove position is less than or equal to 50 µm, and a thickness at the non-groove position may be less than or equal to 500 µm. For example, the thickness at the non-groove position may be 500 µm, 450 µm, 400 µm, 350 µm, 300 µm, 250 µm, 200 µm, 150 µm, 100 µm, 50 µm, or the like.

For example, a thickness of the first impact-resistant layer 92 on two sides is 100 µm, and a thickness of a groove region in the middle is 50 µm. Alternatively, for example, a thickness of the first impact-resistant layer 92 on two sides is 40 µm, and a thickness of a groove region in the middle is 25 µm.

The protective layer 91 is chemically connected to the first impact-resistant layer 92 through the first connection layer 93, and connection reliability of the chemical connection is high. In addition, the first connection layer 93 may be thin, and has little impact on performance of the first impact-resistant layer 92.

FIG. 4A to FIG. 4C are cross-sectional views of a laminated structure according to an embodiment of this application.

In some embodiments, as shown in FIG. 4A, the laminated structure 90 further includes a second impact-resistant layer 94, and the second impact-resistant layer 94 is located on a side that is of the first impact-resistant layer 92 and that is away from the protective layer 91. The first connection layer 93 wraps a surface that is of the first impact-resistant layer 92 and that is away from the protective layer 91, and the second impact-resistant layer 94 is bonded to the first connection layer 93.

In other words, the first connection layer 93 implements a connection between the protective layer 91 and the first impact-resistant layer 92, and further implements a connection between the first impact-resistant layer 92 and the second impact-resistant layer 94.

The laminated structure 90 may include a plurality of impact-resistant layers. The plurality of impact-resistant layers are disposed by reducing a thickness of each impact-resistant layer, so that overall stiffness and hardness of the plurality of impact-resistant layers remain unchanged, but an elastic modulus of the plurality of impact-resistant layers can be increased, to further improve impact resistance performance, scratch resistance performance, extrusion resistance performance, and bending resistance performance of the laminated structure 90. In addition, the plurality of impact-resistant layers may be directly bonded through the first connection layer 93, to simplify the laminated structure 90.

In some other embodiments, as shown in FIG. 4B, the laminated structure 90 further includes a second impact-resistant layer 94 and a second connection layer 95, the second impact-resistant layer 94 is located on a side that is of the first impact-resistant layer 92 and that is away from the protective layer 91, the second connection layer 95 is located between the first impact-resistant layer 92 and the second impact-resistant layer 94, and the first impact-resistant layer 92 and the second impact-resistant layer 94 are connected through the second connection layer 95.

For a material and a structure of the second impact-resistant layer 94, refer to the foregoing related descriptions of the material and the structure of the first impact-resistant layer 92. Details are not described herein again.

For a material of the second connection layer 95, in some embodiments, the material of the second connection layer 95 includes an adhesive material, and the second connection layer 95 is separately adhered to the first impact-resistant layer 92 and the second impact-resistant layer 94.

The adhesive material includes, for example, an optically clear adhesive material like an OCA. The first impact-resistant layer 92 and the second impact-resistant layer 94 are connected through the adhesive material. A technology is mature and easy to implement.

In some other embodiments, a material of the second connection layer 95 includes a polymer material, and the second connection layer 95 is bonded to the first impact-resistant layer 92 and the second impact-resistant layer 94.

The polymer material includes, for example, PET, CPI, glass fiber, or a CPI composite material. The first impact-resistant layer 92 and the second impact-resistant layer 94 are chemically bonded through the polymer material, so that a connection effect is good, and a thickness of the second connection layer 95 may be thin.

In some other embodiments, a material of the second connection layer 95 includes an energy-absorbing and impact-resistant material, and the second connection layer 95 is bonded to the first impact-resistant layer 92 and the second impact-resistant layer 94.

The energy-absorbing and impact-resistant material includes, for example, a non-Newtonian fluid material. In this case, for a structural relationship between the second connection layer 95 and the first impact-resistant layer 92 and the second impact-resistant layer 94, refer to the foregoing related descriptions of a structural relationship between the first connection layer 93 and the first impact-resistant layer 92. Details are not described herein again.

In this embodiment of this application, the plurality of impact-resistant layers may also be connected in a plurality of manners such as chemical bonding and adhering through a connection layer, and has a wide application scope.

In some embodiments, a thickness of the laminated structure 90 is less than or equal to 600 µm. For example, the thickness of the laminated structure 90 is 600 µm, 550 µm, 500 µm, 450 µm, 400 µm, 350 µm, 300 µm, 250 µm, 200 µm, or 150 µm.

The laminated structure 90 provided in this embodiment of this application can be thin while satisfying a reliability requirement, to satisfy a requirement of lightening and thinning the electronic device 1.

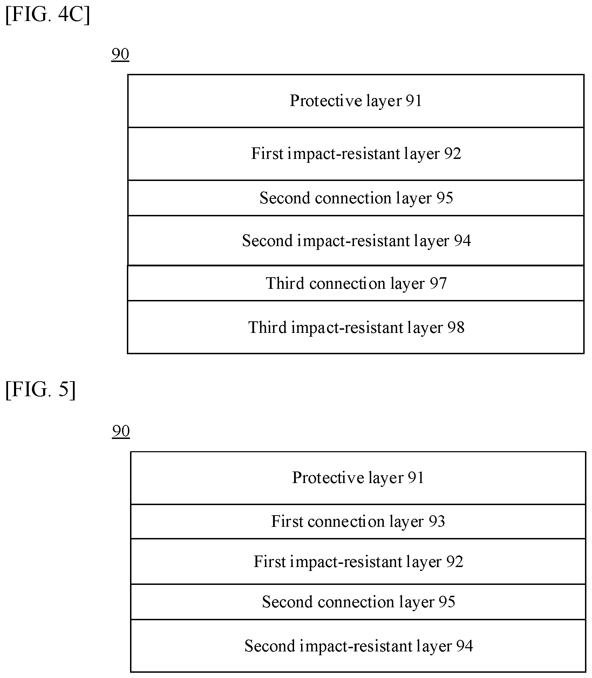

In some embodiments, as shown in FIG. 4C, the laminated structure 90 further includes a third connection layer 97 and a third impact-resistant layer 98 that are sequentially disposed on a side that is of the second impact-resistant layer 94 and that is away from the second connection layer 95.

For the third connection layer 97, refer to the foregoing related descriptions of the second connection layer 95. For the third impact-resistant layer 98, refer to the foregoing related descriptions of the first impact-resistant layer 92. Details are not described herein again. Certainly, the laminated structure 90 may further include a plurality of connection layers and impact-resistant layers that are alternately disposed.

When the laminated structure 90 includes a plurality of impact-resistant layers, thicknesses of the plurality of impact-resistant layers are not limited to be the same, and structures of the plurality of impact-resistant layers are not limited to be the same, provided that the thicknesses and structures are adaptively set based on a product structure.

The plurality of impact-resistant layers are disposed by reducing a thickness of each impact-resistant layer, so that overall stiffness and hardness of the plurality of impact-resistant layers remain unchanged, but an elastic modulus of the plurality of impact-resistant layers can be increased, to further improve impact resistance performance, scratch resistance performance, extrusion resistance performance, and bending resistance performance of the laminated structure 90.

In some embodiments, a side surface of the laminated structure 90 is perpendicular to the protective layer 91. Approximate perpendicularity within a process error range belongs to perpendicularity in this embodiment of this application. For example, all angles within a range of 90°±10° indicate that the side surface is perpendicular to the protective layer 91 in this embodiment of this application.

The side surface of the laminated structure 90 is perpendicular to the protective layer 91, so that strength at each position of the laminated structure 90 is even, and protection strength of the laminated structure 90 at each position of the display 20 is almost the same, thereby alleviating a problem of a poor protection effect at an edge of the display 20.

FIG. 5 is a cross-sectional view of a laminated structure according to an embodiment of this application.

In some embodiments, as shown in FIG. 5, the laminated structure 90 further includes a protective layer 91, a first impact-resistant layer 92, a first connection layer 93, a second connection layer 95, and a second impact-resistant layer 94. The first connection layer 93 is an adhesive layer, and is adhered between the protective layer 91 and the first impact-resistant layer 92. The second connection layer 95 is bonded between the first impact-resistant layer 92 and the second impact-resistant layer 94.

For structures of the protective layer 91, the first impact-resistant layer 92, the second connection layer 95, and the second impact-resistant layer 94, refer to the foregoing related descriptions. Details are not described herein again.

A material of the first connection layer 93 includes, for example, a clear adhesive material like an OCA. In this embodiment of this application, the protective layer 91 and the first impact-resistant layer 92 may alternatively be connected through an adhesive material, to satisfy a plurality of use requirements.

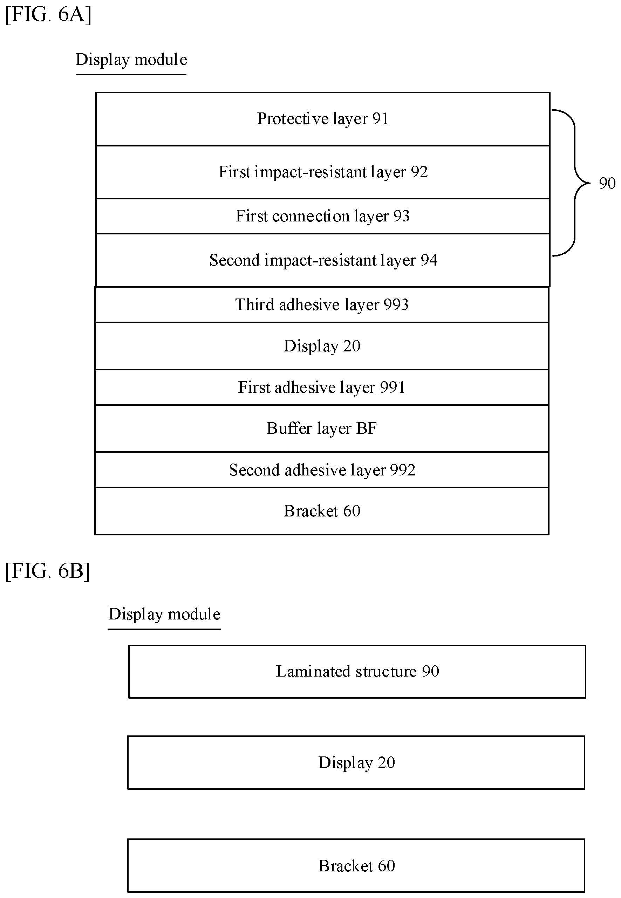

FIG. 6A is a cross-sectional view of a display module according to an embodiment of this application. FIG. 6B is a simplified diagram of a display module according to an embodiment of this application.

An embodiment of this application provides a display module. As shown in FIG. 6A, the display module includes any one of the foregoing laminated structures 90 and a display 20. The laminated structure 90 is disposed on the display 20, and a light-emitting surface of the display 20 faces a second impact-resistant layer 94.

For example, the display module further includes a third adhesive layer 993, the third adhesive layer 993 is located between the laminated structure 90 and the display 20, and two sides of the third adhesive layer 993 are respectively connected to the laminated structure 90 and the display 20.

The laminated structure 90 and the display 20 are directly adhered through the third adhesive layer 993, and no other film layer needs to be disposed between the laminated structure 90 and the display 20. This can simplify a structure of the display module, and reduce a gap between the display 20 and the laminated structure 90, thereby reducing an overall size of the display module.

In some embodiments, as shown in FIG. 6A, the display module further includes a first adhesive layer 991, a buffer layer BF, a second adhesive layer 992, and a bracket 60 that are sequentially disposed on a backlight surface of the display 20, the buffer layer BF is connected to the display 20 through the first adhesive layer 991, and the bracket 60 is connected to the buffer layer BF through the second adhesive layer 992.

A support layer 50 is no longer disposed on the backlight surface of the display 20, so that an architecture of the display module can be further simplified, a thickness of the display module can be reduced, and the display module can be simplified, light, and thin.

In some embodiments, an elastic modulus of the bracket 60 is greater than or equal to 10 GPa. For example, the elastic modulus of the bracket 60 may be 10 GPa, 50 GPa, 100 GPa, 150 GPa, 200 GPa, 250 GPa, 300 GPa, 350 GPa, 400 GPa, 450 GPa, 500 GPa, 550 GPa, 600 GPa, 650 GPa, 700 GPa, 750 GPa, 800 GPa, 850 GPa, 900 GPa, 950 GPa, 1000 GPa, 1500 GPa, or the like.

For example, a material of the bracket 60 includes carbon fiber, graphite fiber, asphalt base, a high-entropy alloy, stainless steel, a titanium alloy, a composite material of asphalt base and metal (for example, aluminum, titanium, or steel), a composite material of carbon fiber and metal, or the like.

A material with a high elastic modulus is selected as the material of the bracket 60, so that impact resistance performance of the bracket 60 can be improved, and fineness of a crease and a large-area light shadow can be improved, thereby improving reliability and fineness of the display module while simplifying the architecture of the display module.

In some embodiments, the bracket 60 includes a first part and a second part, the second part is separately disposed on two opposite sides of the first part, and an elastic modulus of the first part is less than an elastic modulus of the second part. In other words, an elastic modulus of a middle part of the bracket 60 is less than elastic moduli of two side parts. For example, the first part corresponds to a position of a foldable display portion 203 of the display 20.

The elastic modulus in a middle region of the bracket 60 is reduced, so that bendability of a middle bending region can be ensured, and performance of the display module can be further improved.

For example, materials of the first part and the second part of the bracket 60 are the same, but structures of the first part and the second part are different, so that the elastic modulus of the first part is less than the elastic modulus of the second part. Materials of parts of the bracket 60 are the same, so that material types of the bracket 60 can be reduced.

Alternatively, for example, materials of the first part and the second part of the bracket 60 are different, so that the elastic modulus of the first part is less than the elastic modulus of the second part. Different materials are used at different modulus positions of the bracket 60, so that processability of the bracket 60 can be improved.

In some embodiments, as shown in FIG. 6A, a projection of the laminated structure 90 on the buffer layer BF covers a projection of the display 20 on the buffer layer BF.

The laminated structure 90 can protect the display 20, to alleviate a problem that a weak edge extrusion region is prone to damage, and further improve reliability of the display module.

As shown in FIG. 6B, the display module may be simplified to include the laminated structure 90, the display 20, and the bracket 60, and no support layer may be disposed between the bracket 60 and the display 20.

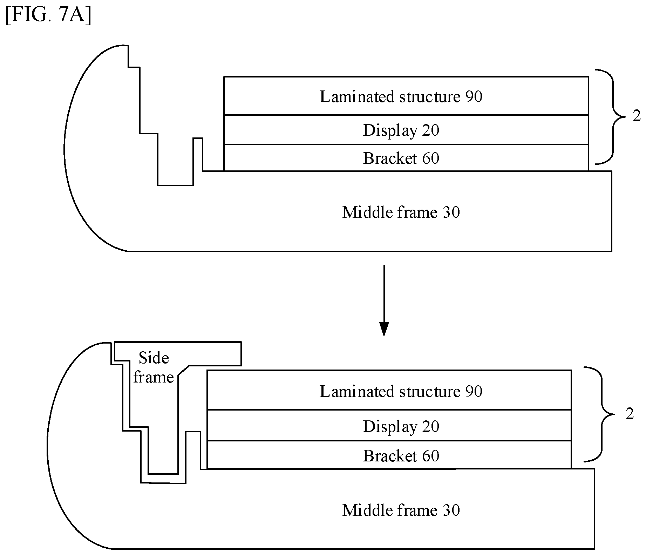

FIG. 7A to FIG. 7C are assembly diagrams of an electronic device according to an embodiment of this application.

In some embodiments, as shown in FIG. 7A, the electronic device 1 provided in this embodiment of this application further includes a side frame, and the side frame is located on a periphery of a display 20 and extends above a laminated structure 90 to lap over the laminated structure 90.

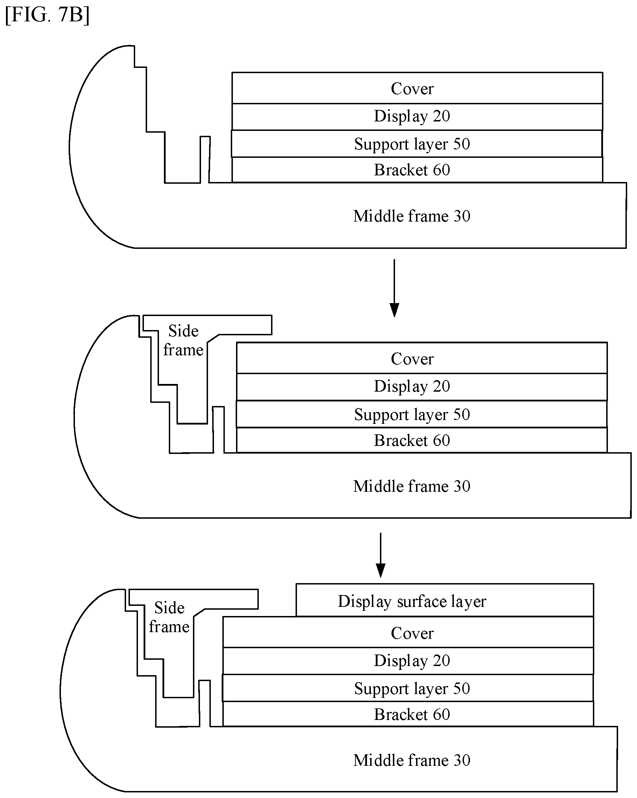

The side frame may also be referred to as an "A cover", and is one of important parts of the foldable electronic device 1. Because the display 20 is misplaced when being bent, a gap in a horizontal direction needs to be reserved between a side wall of a middle frame 30 and the display 20. As shown in FIG. 7B, during assembly of the electronic device, a laminated layer formed by a cover, the display 20, a support layer 50, and a bracket 60 is first placed on the middle frame 30. Then, the side frame is placed. The side frame is located between the middle frame 30 and the display 20, and laps over a surface of the cover. The side frame is used to shield the gap between the display 20 and the middle frame 30, and protect an edge of the electronic device 1 against pressing. Then, a display surface layer is placed on the surface of the cover. To absorb an assembly tolerance, there is a gap between the display surface layer and the side frame, affecting visual aesthetics.

As shown in FIG. 7A, an assembly process of the electronic device 1 provided in this embodiment of this application is as follows: First, a display module 2 including the laminated structure 90, the display 20, and the bracket 60 is placed on the middle frame 30. A "simplified" architecture can further reduce a thickness of the laminated layer. Therefore, the laminated structure 90 can cover the display 20, and the laminated structure 90 can protect, to a specific extend, the edge of the electronic device 1 against pressing, to alleviate a bright line problem caused by fingernail pressing in an edge region. Then, the side frame is placed. The side frame is located between the middle frame 30 and the display 20, and laps over a surface of the laminated structure 90. In this case, there is no gap between the side frame and the laminated structure 90, to improve an aesthetic effect and alleviate a dust absorption problem. In addition, the laminated structure 90 protects the edge of the electronic device 1 against pressing, so that a requirement of protecting the side frame can be reduced, to reduce a width of the side frame, and implement a "narrow side frame" effect. In addition, in the assembly process, the display surface layer and the cover are integrated in the laminated structure 90 in this application. Therefore, after the side frame is assembled, a procedure of attaching the display surface layer does not need to be performed, thereby simplifying the assembly process of the electronic device 1.

In some embodiments, a width of a projection of the side frame on a plane on which the display module is located is less than or equal to 0.5 mm.

A width of the side frame may be understood as a size between an edge that is of the side frame and that is close to the display module and an edge that is of the side frame and that is close to the middle frame. For example, the width of the side frame may be 0.5 mm, 0.45 mm, 0.4 mm, 0.35 mm, 0.3 mm, 0.25 mm, 0.2 mm, 0.15 mm, or 0.1 mm.

Because the laminated structure 90 protects the edge of the electronic device 1 against pressing, the side frame may not need to play a protective role, and the side frame only needs to fill a gap between the display module and the middle frame 30. Therefore, the width of the side frame can be reduced.

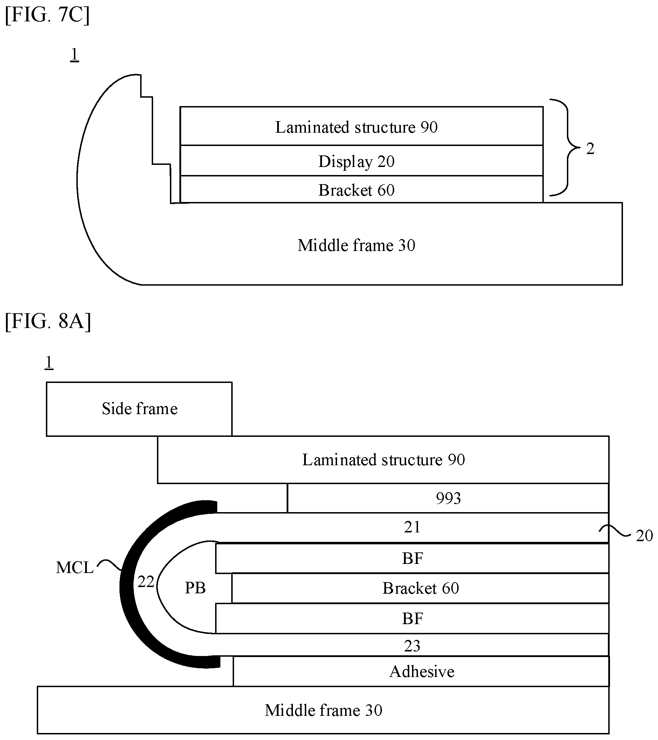

In some embodiments, as shown in FIG. 7C, the electronic device 1 includes the middle frame 30, and the display module is disposed on the middle frame 30. For example, a side surface of the display module is disposed adjacent to the middle frame 30. The side frame is no longer disposed between the display module and the middle frame 30, provided that the gap between the display module and the middle frame 30 is sufficient for the display 20 to be misplaced when being bent.

No side frame is disposed between the display module and the middle frame 30, so that the "narrow side frame" effect can be further implemented.

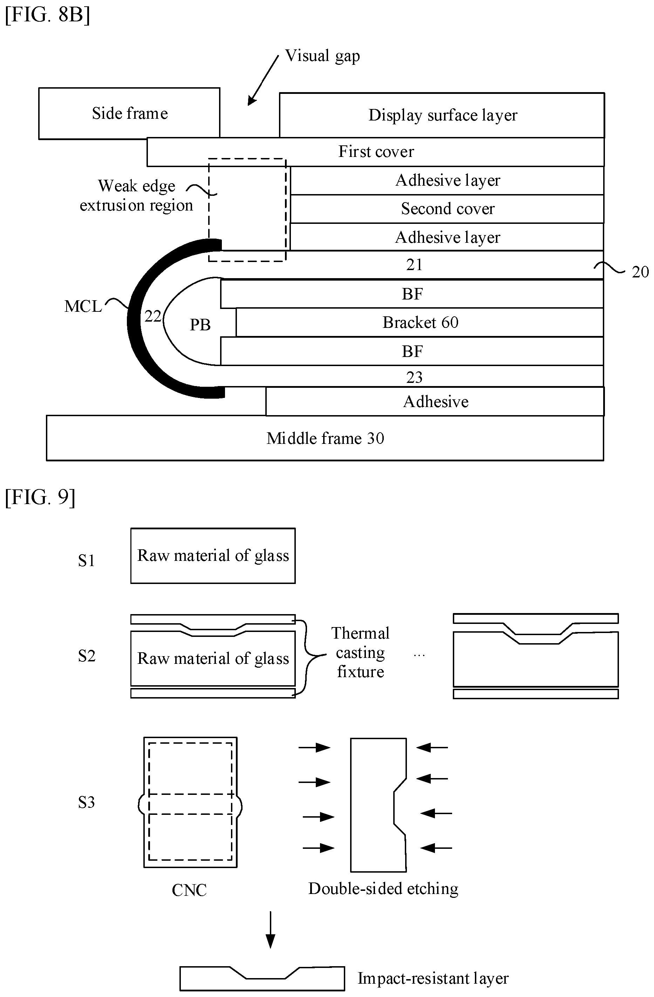

FIG. 8A and FIG. 8B are cross-sectional views of an electronic device according to an embodiment of this application.

As shown in FIG. 8A, in some embodiments, a display 20 includes a first plane portion 21, a bending portion 22, and a second plane portion 23, the bending portion 22 is connected between the first plane portion 21 and the second plane portion 23, the first plane portion 21 is connected to a laminated structure 90, and the second plane portion 23 is located on a backlight side of the first plane portion 21. A bracket 60 is disposed between the first plane portion 21 and the second plane portion 23, and buffer layers BF are disposed on upper and lower sides of the bracket 60. The second plane portion 23 is connected to a middle frame 30 through an adhesive.

The electronic device 1 further includes a module coating layer MCL, and the module coating layer MCL covers the bending portion 22.

As shown in FIG. 8B, when a display surface layer and a cover are disposed at an upper part of the display 20, a first cover and a second cover are usually disposed at the upper part of the display 20. The first cover and the second cover are adhered through an adhesive layer, and the first cover and the display surface layer are adhered through an adhesive layer.

There is a module coating layer (module coating layer, MCL) in a pad bonding (pad bonding, PB) region of the electronic device 1. Therefore, to avoid that the second cover is in contact with the module coating layer MCL when being bent and misplaced, a gap is reserved between the second cover located at the upper part of the display 20 and the module coating layer MCL. There is only a thin first cover (CPI/PET) above the gap, which is a weak edge extrusion region. As a result, a fingernail pressing failure in the pad bonding PB region is caused.

As shown in FIG. 8A, in the electronic device 1 in this application, the display 20 is directly connected to the laminated structure 90. On the premise of ensuring extrusion/impact reliability, in a "simplified" architecture, the second cover can be removed, to reduce a thickness of the module coating layer MCL, thereby further reducing a thickness of a laminated layer.

In some embodiments, the thickness of the module coating layer MCL ranges from 50 µm to 90 µm.

The thickness of the module coating layer MCL may be understood as a size between a surface that is of the module coating layer MCL and that faces the bending portion 22 and a surface that is of the module coating layer MCL and that is away from the bending portion 22. Thicknesses of the module coating layer MCL at positions may be equal or unequal. For example, the thickness of the module coating layer MCL may be 90 µm, 85 µm, 80 µm, 75 µm, 70 µm, 65 µm, 60 µm, 55 µm, or 50 µm.

In this embodiment of this application, only a third adhesive layer 993 may be disposed between the display 20 and the laminated structure 90. Therefore, a gap between the first plane portion 21 and the laminated structure 90 may be small, so that a thickness of the electronic device 1 can be reduced. Moreover, no support layer needs to be disposed between the first plane portion 21 and the second plane portion 23, so that the thickness of the module coating layer MCL can be reduced, and a "narrow side frame" effect can be further implemented.

In some embodiments, the laminated structure 90 covers the display 20. When the display 20 includes the bending portion 22, because the bending portion 22 and the second plane portion 23 do not have a display function, that the laminated structure 90 covers the display 20 may be understood as that the laminated structure 90 covers the first plane portion 21.

In this embodiment of this application, the laminated structure 90 can protect the weak edge extrusion region and the pad bonding PB region located below the laminated structure 90, to improve edge reliability of the electronic device 1.

FIG. 9 is a diagram of a process of preparing an impact-resistant layer according to an embodiment of this application.

An embodiment of this application further provides a method for preparing an impact-resistant layer. As shown in FIG. 9, the preparation method includes:
S1: Provide a raw material of glass.

For example, raw glass of 150 µm to 400 µm may be selected, and the raw glass is cut into a raw material of glass of 4 inches to 20 inches based on a product requirement.

S2: Place the raw material of glass in a thermal casting fixture with a protrusion on an inner surface to perform thermal casting, to form a glass plate with a groove on a surface.

In FIG. 9, an example in which one surface of the glass plate has a groove is used for illustration. After thermal casting is performed, two surfaces of the glass plate may have grooves. The thermal casting step may be performed once or a plurality of times based on a requirement of a target product. In FIG. 9, an example in which the thermal casting step is performed twice is used for illustration.

For example, a temperature of the thermal casting is greater than or equal to a glass softening temperature. For example, the temperature of the thermal casting ranges from 600°C to 1000°C. The inner surface of the thermal casting fixture may be understood as a surface that is of the thermal casting fixture and that faces the raw material of glass.

S3: Trim the glass plate to a target size to form the impact-resistant layer, where there is a groove on an upper surface and/or a lower surface of the impact-resistant layer.

For example, step S3 includes: trimming a length and a width of the glass plate through laser or computer numerical control (computer numerical control, CNC) machining, and trimming a thickness of the glass plate by using an etching process. A thickness direction of the glass plate is, for example, a direction from a surface on which a groove is formed to an opposite surface.

The etching process may be a double-sided etching process, to accelerate an etching speed. Certainly, a single-sided etching process may alternatively be used. For example, etching liquid used in the etching process may include a mixed acid like hydrofluoric acid, sulfuric acid, and nitric acid. After the thickness is reduced to a target size, steps such as cleaning, edge processing, and strengthening may be performed, to finally form the impact-resistant layer with unequal thicknesses.

In some embodiments, before or after trimming the glass plate to the target size, the preparation method further includes: polishing the glass plate, to improve an optical effect of the impact-resistant layer.

In this embodiment of this application, the impact-resistant layer may be formed by using a thermal casting process, so that processing efficiency and processability of the impact-resistant layer with unequal thicknesses can be improved, and mass production can be implemented.

An embodiment of this application provides an impact-resistant layer, used in the electronic device 1. The impact-resistant layer has a first surface and a second surface that are opposite to each other, where one of the first surface and the second surface is a surface facing a protective layer 91, and the other is a surface away from the protective layer 91. There is a groove on the first surface and/or the second surface.

The impact-resistant layer may be, for example, the first impact-resistant layer 92 or the second impact-resistant layer 94.

An embodiment of this application further provides a thermal casting fixture, configured to prepare the impact-resistant layer. The thermal casting fixture includes a first component and a second component. In an application state, there is a protrusion on a surface that is of the first component and that faces the second component, and/or there is a protrusion on a surface that is of the second component and that faces the first component.

Materials of the first component and the second component include, for example, graphite or stainless steel. The first component and the second component are matched as a male and female mold. If there is a groove on only one surface of the to-be-formed impact-resistant layer, there is a protrusion on a surface of the first component or a surface of the second component, and the protrusion faces a raw material of glass. If there is a groove on each of two opposite surfaces of the to-be-formed impact-resistant layer, there is a protrusion on each of the surface of the first component and the surface of the second component, and the protrusion faces the raw material of glass. A width and a height of the protrusion are related to a size of the to-be-formed groove, and the width and the height of the protrusion are selected based on a design of expanding a region with unequal thicknesses based on an expansion coefficient of the raw material of glass.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A laminated structure, wherein the laminated structure is disposed on a display, and the laminated structure comprises:
a protective layer; and
a first impact-resistant layer, located on a side of the protective layer and connected to the protective layer, wherein an elastic modulus of the first impact-resistant layer is less than an elastic modulus of the protective layer, hardness of the first impact-resistant layer is greater than hardness of the protective layer, and/or stiffness of the first impact-resistant layer is greater than stiffness of the protective layer.

2. The laminated structure according to claim 1, wherein the protective layer is bonded to the first impact-resistant layer.

3. The laminated structure according to claim 1, wherein the laminated structure further comprises a first connection layer, and the first connection layer is bonded between the protective layer and the first impact-resistant layer.

4. The laminated structure according to claim 3, wherein the laminated structure further comprises a second impact-resistant layer, and the second impact-resistant layer is located on a side that is of the first impact-resistant layer and that is away from the protective layer; and
the first connection layer wraps a surface that is of the first impact-resistant layer and that is away from the protective layer, and the second impact-resistant layer is bonded to the first connection layer.

5. The laminated structure according to any one of claims 1 to 3, wherein the laminated structure further comprises a second impact-resistant layer and a second connection layer, the second impact-resistant layer is located on a side that is of the first impact-resistant layer and that is away from the protective layer, and the second connection layer is connected between the first impact-resistant layer and the second impact-resistant layer.

6. The laminated structure according to any one of claims 1 to 5, wherein a material of the first impact-resistant layer comprises ultra-thin glass or high-entropy glass.

7. The laminated structure according to any one of claims 1 to 6, wherein a material of the first connection layer comprises an energy-absorbing and impact-resistant material.

8. The laminated structure according to any one of claims 1 to 7, wherein a material of the protective layer comprises polyethylene terephthalate, colorless polyimide, or glass fiber.

9. The laminated structure according to any one of claims 5 to 8, wherein a material of the second connection layer comprises a polymer material or an energy-absorbing and impact-resistant material, and the second connection layer is separately bonded to the first impact-resistant layer and the second impact-resistant layer.

10. The laminated structure according to any one of claims 5 to 9, wherein the material of the second connection layer comprises an adhesive material, and the second connection layer is separately adhered to the first impact-resistant layer and the second impact-resistant layer.

11. The laminated structure according to any one of claims 1 to 10, wherein a groove is provided on a surface that is of the first impact-resistant layer and that faces the protective layer and/or the surface that is of the first impact-resistant layer and that is away from the protective layer.

12. The laminated structure according to any one of claims 1 to 11, wherein a size of the first impact-resistant layer at a thinnest position is less than or equal to 50 µm.

13. The laminated structure according to any one of claims 1 to 12, wherein a thickness of the laminated structure is less than or equal to 600 µm.

14. The laminated structure according to any one of claims 1 to 13, wherein a side surface of the laminated structure is perpendicular to the protective layer.

15. A laminated structure, wherein the laminated structure is disposed on a display, and the laminated structure comprises:
a protective layer;
a first connection layer, adhered between the protective layer and first impact-resistant layer;
the first impact-resistant layer, located on a side of the protective layer, wherein an elastic modulus of the first impact-resistant layer is less than an elastic modulus of the protective layer, hardness of the first impact-resistant layer is greater than hardness of the protective layer, and/or stiffness of the first impact-resistant layer is greater than stiffness of the protective layer;
a second impact-resistant layer, located on a side that is of the first impact-resistant layer and that is away from the protective layer; and
a second connection layer, bonded between the first impact-resistant layer and the second impact-resistant layer.

16. A display module, wherein the display module comprises a display and a laminated structure, the laminated structure comprises the laminated structure according to any one of claims 1 to 15, and the laminated structure is disposed on the display.

17. The display module according to claim 16, wherein the display module further comprises a first adhesive layer, a buffer layer, a second adhesive layer, and a bracket that are sequentially disposed on a backlight surface of the display, the buffer layer is connected to the display through the first adhesive layer, and the bracket is connected to the buffer layer through the second adhesive layer.

18. The display module according to claim 17, wherein an elastic modulus of the bracket is greater than or equal to 10 GPa.

19. The display module according to claim 17 or 18, wherein the bracket comprises a first part and a second part, the second part is separately disposed on two opposite sides of the first part, and an elastic modulus of the first part is less than an elastic modulus of the second part.

20. The display module according to any one of claims 17 to 19, wherein a material of the bracket comprises carbon fiber, graphite fiber, asphalt base, a high-entropy alloy, stainless steel, a titanium alloy, a composite material of asphalt base and metal, or a composite material of carbon fiber and metal.

21. The display module according to any one of claims 17 to 20, wherein a projection of the laminated structure on the buffer layer covers a projection of the display on the buffer layer.

22. The display module according to any one of claims 16 to 21, wherein the display module further comprises a third adhesive layer, and two sides of the third adhesive layer are respectively connected to the laminated structure and the display.

23. The display module according to any one of claims 16 to 22, wherein the display comprises a first plane portion, a bending portion, and a second plane portion, the bending portion is connected between the first plane portion and the second plane portion, the first plane portion is connected to the laminated structure, and the second plane portion is located on a backlight side of the first plane portion; and
the display module further comprises a module coating layer, the module coating layer covers the bending portion, and a thickness of the module coating layer ranges from 50 µm to 90 µm.

24. An electronic device, wherein the electronic device comprises a display module and a middle frame, the display module is disposed on the middle frame, and the display module comprises the display module according to any one of claims 16 to 23.

25. The electronic device according to claim 24, wherein the electronic device further comprises a side frame, and the side frame is located on a periphery of the display module and extends above laminated structure to lap over the laminated structure.

26. The electronic device according to claim 25, wherein a width of a projection of the side frame on a plane on which the display module is located is less than or equal to 0.5 mm.

27. The electronic device according to any one of claims 24 to 26, wherein a side surface of the display module is disposed adjacent to the middle frame.

28. The electronic device according to any one of claims 24 to 27, wherein the electronic device further comprises a rear cover, the rear cover comprises a first housing, a second housing, and a hinge mechanism, and the first housing and the second housing are disposed on two sides of the hinge mechanism; and
the first housing and the second housing move towards or away from each other through the hinge mechanism, so that the display module is switched between an unfolded state and a folded state.

29. A method for preparing an impact-resistant layer, comprising:
providing a raw material of glass;
placing the raw material of glass in a thermal casting fixture with a protrusion on an inner surface to perform thermal casting, to form a glass plate with a groove on a surface; and
trimming the glass plate to a target size to form the impact-resistant layer, wherein there is a groove on an upper surface and/or a lower surface of the impact-resistant layer.

30. The preparation method according to claim 29, wherein before or after trimming the glass plate to the target size, the preparation method further comprises: polishing the glass plate.

31. The preparation method according to claim 29 or 30, wherein trimming the glass plate to the target size comprises:
trimming a length and a width of the glass plate through laser or computer numerical control machining;
and/or
trimming a thickness of the glass plate by using an etching process.

32. The preparation method according to any one of claims 29 to 31, wherein a temperature of the thermal casting ranges from 600°C to 1000°C.

33. An impact-resistant layer, wherein the impact-resistant layer is used in an electronic device comprising a display, the impact-resistant layer has a first surface and a second surface that are opposite to each other, and there is a groove on the first surface and/or the second surface.

34. The impact-resistant layer according to claim 33, wherein a material of the impact-resistant layer comprises ultra-thin glass or high-entropy glass.

35. The impact-resistant layer according to claim 33 or 34, wherein a size of the impact-resistant layer at a thinnest position is less than or equal to 50 µm.

36. A thermal casting fixture, comprising:
a first component and a second component, wherein there is a protrusion on a surface that is of the first component and that faces the second component, and/or there is a protrusion on a surface that is of the second component and that faces the first component.
